# EUROPEAN PATENT APPLICATION

(11) **EP 0 661 712 A2**
(43) Date of publication of application: **05.07.1995**
(21) Application number: 94308252.9
(22) Date of filing: 09.11.1994
(51) Int. Cl.: G11C 16/04, G11C 11/402

(54) **A non-volatile memory**

(30) Priority: 29.12.1993 US 174724
(71) Applicant: International Business Machines Corporation, Armonk, N.Y. 10504 (US)
(72) Inventor: Riggio, Salvatore Richard, Jr., Boca Raton, Florida 33486-6409 (US)
(74) Representative: Davies, Simon Robert

(57) **Abstract**

A non-volatile memory includes a floating gate transistor (e.g., Q15) capable of storing charge (representing a binary 1 or 0) on the floating gate for extended, although not indefinite, periods of time. To refresh any charge that leaks off the floating gate, refresh circuitry (e.g., Q17-Q19) is provided to restore the charge on the gate to its original logical state. This refresh circuitry may be activated on a periodic basis, for example, weekly or monthly, or on an aperiodic basis, such as at "power-up." Each of the transistors in the memory are preferably thin film, amorphous silicon, "N" type transistors, including the floating gate transistor.

## Description

This invention pertains to memories and, more particularly, to a non-volatile memory that utilizes thin film, amorphous transistors, including a floating gate transistor.

Computers currently use two primary types of read/write memory. Specifically, read/write semiconductor memory (commonly called RAM or random access memory) and magnetic disk memory (for example, "hard" or "floppy" disk drives). Read/write semiconductor memory or RAM is characterized by fast access times, high storage density (bits/cm³), relative high cost per bit of data storage, volatility (volatility is the characteristic whereby data stored in memory is lost as soon as electrical power is removed from the memory) and a lack of moving parts. Magnetic disk memory is characterized by slow access times, low storage density, low cost per bit, non-volatility and moving parts.

The present invention provides a non-volatile memory that includes a data storing means and a means for refreshing the data storing means. The data storing means includes an amorphous thin film, floating gate transistor.

The memory provides many of the advantages of read/write semiconductor memory, such as fast access time, high storage density and lack of moving parts, with the primary advantage of magnetic disc memory; specifically, non-volatility. In addition, because of the ability to produce this memory on large, single amorphous substrates (rather than the relatively small crystalline substrates of conventional semiconductor devices), this new memory design has the potential to offer a very low cost per bit of data storage.

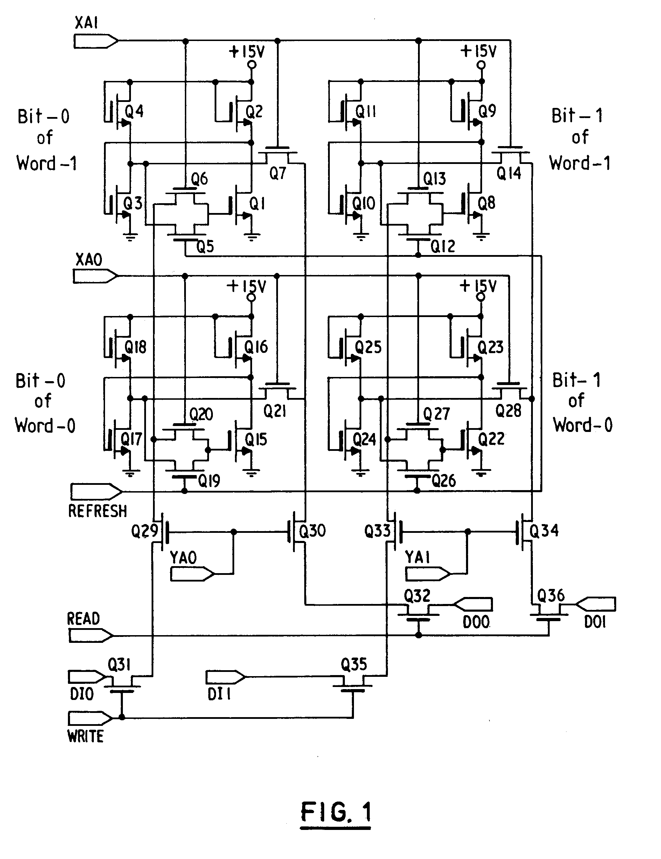

Figure 1 is a schematic diagram of a non-volatile memory in accordance with the current invention.

Figure 1 is a schematic diagram of an illustrative embodiment of the non-volatile memory of the present invention. In the particular embodiment of Figure 1, four memory cells are illustrated for storing a total of four bits of data. The first memory cell consists of transistors Q1 through Q7, the second cell consists of transistors Q8 through Q14, the third cell consists of transistors Q15 through Q21, and the fourth cell consists of transistors Q22 through Q28. Although only four cells are illustrated, it should be apparent to one of skill in the art that this four celled memory can easily be expanded (or reduced) to any number of desired cells.

Each of the transistors in the memory is preferably a thin film, amorphous silicon transistor fabricated by depositing metal, insulating and semiconductor materials by sputtering in a vacuum. Although amorphous silicon is preferred, other semiconductor materials may also be suitable. Note that all the transistors are "N" type transistors. It should also be apparent to one of skill in the art that the memory could also be constructed from all "P" type transistors, or from a mixture of N and P type transistors. However, it should also be readily apparent that there is a distinct advantage in the ability to fabricate the memory using only one type of transistor, N or P.

These thin film transistors call be deposited on a variety of substrate materials, such as glass, quartz or plastic. The substrate material can be either rigid or flexible, and can be comparatively large (for example, 8" by 8"). The construction of thin film transistors is well know in the art. (See, for example, Nick Hall, Jr., Prentice Hall Series In Solid State Physical Electronics, pp 437 - 446, Prentice Hall, 1990).

Each of the memory cells includes a floating gate transistor, which is also fabricated using the thin film process described above. For example, in the third cell, transistor Q15 is a floating gate transistor. Floating gate transistors are well know in the art, and floating gate transistors fabricated using standard diffusion techniques are in common use in electrically erasable programmable read only memories, commonly know as EEPROM's. Briefly, the gate of each floating gate transistors is completely surrounded by insulating material such that, under normal conditions, there is no electrical connection to the floating gate of the transistor. However, when writing to the cell, the programming voltage exceeds the breakdown voltage of the insulating material surrounding the floating gate, causing charge to flow through the insulating material and onto the floating gate (in the case where a logic 1 is to be stored), or causing charge to flow from the gate (in the case where a logic 0 is to be stored). After the write operation is complete, the resistivity of the insulating material surrounding the floating gate is so high, that weeks, months or even years may pass before any charge can leak off.

The operation of the memory will now be described in terms of the write, refresh and read operations as they occur in the third memory cell (Q15 - Q21). To write to the third cell, the data to be written to the cell (either a high voltage or logic 1, or a low voltage or logic 0) is input to the "0" write data input port DI0, and then the "X" address input port XAO, the "Y" address input port YAO, and the WRITE input port are all set to a logic 1 (high voltage). This activates transistors Q20, Q29 and Q31, which function as transmission gates, thereby coupling the write data at input port DI0 to the floating gate of transistor Q15. Therefore, if the write data at input port DIO is a high voltage or logic 1, positive charge will be stored on the floating gate of transistor Q15, thereby switching transistor Q15 ON. If, on the other hand, the write data at input DIO is a low voltage or logic O, no significant charge will be stored on the floating gate of transistor Q15, thereby switching transistor Q15 OFF.

To read data stored in the third memory cell, the "X" address input port XA0, the "Y" address input port YA0 and the READ input port are all set to a logic 1, thereby switching ON transistors Q21, Q30 and Q32, which also function as transmission gates. Transistor Q16 functions as a load for transistor Q15; consequently, if a high voltage or logic 1 is stored on the floating gate of transistor Q15, transistor Q15 will be switched ON and the drain of Q15 will be pulled close to ground potential. Similarly, if a low voltage or logic 0 is stored on the floating gate of transistor Q15, transistor Q15 will be switched OFF and the drain of Q15 will be pulled to a high voltage or logic 1 by transistor Q16. Since transistors Q17 and Q18 are interconnected as an inverter, the logical state of the voltage at the drain of Q15 will be inverted and coupled to the input of transistor/transmission gate Q21. Since Q21, Q30 and Q32 are currently switched ON, the output of inverter Q17/Q18 is coupled to the data output port DO0. Note that the logical state of the data stored on the floating gate of transistor Q15 is inverted twice during a read operation. The first inversion occurs at the drain of transistor Q15, while the second occurs in the inverter Q17/Q18. Consequently, the logical state of the output of the memory cell is identical to the logical state of the data stored on the floating gate of transistor Q15.

Although the data stored on the floating gate of transistor Q15 is "non-volatile", i.e., it will not be lost when the power is removed from the memory, the data is not "permanent" since any charge stored on the floating gates of the various memory cells tends to leak off with time. The time that it takes to leak off enough charge to cause a logic 1 to change to a logic 0 depends, of course, on the design characteristics of the floating gate transistors. However, this time is currently on the order of weeks or months. Therefore, the "refreshing" of the data stored on the floating gates need only occur at some very long periodic time interval, such as every week, or possibly at some aperiodic time such as at "power-up" (i.e., every time the power to the computer is turned ON).

To refresh the memory cells, the refresh control port REFRESH is raised to a high voltage or logic 1, thereby turning ON transistor/transmission gate Q19 in the third cell, as well as transistors/transmission gates Q5, Q12 and Q26 in the first, second and fourth memory cells, respectively. Since the data stored on the floating gate of transistor Q15 appears inverted at the drain of Q15, and since the data at the drain of Q15 is inverted by inverter Q17/Q18, the output of inverter Q17/Q18 is "in phase" with the data on the floating gate of transistor Q15. With transmission gate Q19 switched ON, the output of inverter Q17/Q18 is coupled back to the floating gate of transistor Q15, thereby refreshing Q15.

Although an illustrative embodiment of the present invention has been described, it should be understood that other variations and embodiments of the invention are possible. For example although each memory cell of the illustrative embodiment includes its own refresh circuitry, it is possible to refresh the cells on a row by row basis, such as is well known in the dynamic RAM art.

## Claims

1. A non-volatile memory, comprising in combination:
data storing means including an amorphous, thin film, floating gate transistor (Q15); and
means (Q17, Q18, Q19) for refreshing said data storing means.

2. The non-volatile memory of claim 1, wherein said means for refreshing includes a plurality of amorphous, thin film transistors.

3. The non-volatile memory of claim 1, wherein:
said means for refreshing includes an inverter (Q17, Q18), said inverter being coupled between a data input and a data output of said data storing means, and the output of said inverter also being coupled to a data output port of said memory, such that said inverter is used both to refresh said data storing means and as a data output driver.

4. The non-volatile memory of claim 3, wherein said inverter includes a plurality of amorphous, thin film transistors.

5. The non-volatile memory of claim 1, wherein said means for refreshing includes an inverter (Q17, Q18) having an output coupled to an input of a transmission gate (Q19), the input of said inverter being coupled to a data output of said data storing means, and an output of said transmission gate being coupled to a data input of said data storing means.

6. The non-volatile memory of claim 5, wherein the output of said inverter is also coupled to a data output port of said memory, such that said inverter is used both to refresh said data storing means and as a data output driver.

7. The non-volatile memory of claim 5 or 6, wherein said inverter and said transmission gate include a plurality of amorphous, thin film transistors.

8. The non-volatile memory of claim 2, 4 or 7, wherein said floating gate transistor and said plurality of amorphous, thin film transistors are all of the same type, N or P.

9. The non-volatile memory of any preceding claim, wherein said data storing means further includes a load transistor (Q16) coupled to said floating gate transistor, said load transistor functioning as a load for said floating gate transistor.
